(19) Europäisches Patentamt
European Patent Office
Office européen des brevets

(11) **EP 4 611 509 A1**

(12) **EUROPEAN PATENT APPLICATION**

(43) Date of publication:
03.09.2025 Bulletin 2025/36

(51) International Patent Classification (IPC):
***H10H 20/819*** (2025.01)

(21) Application number: 24221806.3

(22) Date of filing: 19.12.2024

(52) Cooperative Patent Classification (CPC):
**H10H 20/819; H10H 29/30**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 27.02.2024 KR 20240028058
08.10.2024 KR 20240136522

(71) Applicant: **LG Display Co., Ltd.**
**Seoul, 07336 (KR)**

(72) Inventors:
• **YU, Hyeonhye**
**10845 Paju-si (KR)**
• **PARK, SeHong**
**10845 Paju-si (KR)**
• **KIM, GiBin**
**10845 Paju-si (KR)**

(74) Representative: **Ter Meer Steinmeister & Partner**
**Patentanwälte mbB**
**Nymphenburger Straße 4**
**80335 München (DE)**

(54) **LIGHT-EMITTING ELEMENT AND DISPLAY DEVICE HAVING THE SAME**

(57) A light-emitting element includes a first semiconductor layer, a second semiconductor layer opposite to the first semiconductor layer, and a light-emitting layer between the first semiconductor layer and the second semiconductor layer, in which planar shapes of the first semiconductor layer, the second semiconductor layer, and the light-emitting layer each include at least one first side with a straight shape, and at least one second side with a curved shape.

ED

FIG. 2

EP 4 611 509 A1

## Description

This application claims the priority of Republic of Korea Patent Application No. 10-2024-0028058 filed on February 27, 2024 and Republic of Korea Patent Application No. 10-2024-0136522 filed on October 8, 2024.

Field

The present disclosure relates to a light-emitting element and a display device including the same, and more particularly, to a light-emitting element with improved external light extraction efficiency, and a display device including the same.

## BACKGROUND

As display devices used for a monitor of a computer, a TV set, a mobile phone, and the like, there are an organic light-emitting display (OLED) configured to autonomously emit, and a liquid crystal display (LCD) that requires a separate light source.

The range of application of the display devices is diversified from the monitor of the computer and the TV set to personal mobile devices, and studies are being conducted on the display devices having wide display areas and having reduced volumes and weights.

In addition, recently, a display device including a light-emitting diode (LED) has attracted attention as a next-generation display device. Because the LED is made of an inorganic material instead of an organic material, the LED is more reliable and has a longer lifespan than a liquid crystal display device or an organic light-emitting display device. In addition, the LED may be quickly turned on or off, have excellent luminous efficiency, high impact resistance, and great stability, and display high-brightness images.

## SUMMARY

An object to be achieved by the present disclosure is to provide a light-emitting element with improved light extraction efficiency, and a display device including the same.

Another object to be achieved by the present disclosure is to provide a light-emitting element, in which light emitted from the light-emitting element is extracted in a direction toward a front surface of a display device, and a display device including the same.

Objects of the present disclosure are not limited to the above-mentioned objects, and other objects, which are not mentioned above, can be clearly understood by those skilled in the art from the following descriptions.

At least one of these objects is solved by the subject-matter of the independent claims. Refinements and advantageous embodiments are defined by the respective dependent claims.

A light-emitting element according to an embodiment of the present disclosure includes: a first semiconductor layer; a second semiconductor layer opposite to the first semiconductor layer; and a light-emitting layer between the first semiconductor layer and the second semiconductor layer, in which planar shapes of the first semiconductor layer, the second semiconductor layer, and the light-emitting layer each include at least one first side with a straight shape or line, and at least one second side with a curved shape or line.

A display device according to an embodiment of the present disclosure includes: a substrate including a plurality of subpixels; a plurality of transistors disposed on the substrate; and a light-emitting element disposed in each of the plurality of subpixels on the substrate.

A display device according to an embodiment of the present disclosure includes: a substrate comprising a plurality of subpixels; a plurality of transistors on the substrate; a light-emitting element according to any one of the herein described embodiments, the light-emitting element being disposed in one of the plurality of subpixels on the substrate; and a planarization layer on the plurality of transistors and surrounding a side surface of the light-emitting element.

Within the present disclosure, a planar shape may be defined as the shape of a (light-emitting) element, electrode or layer when viewed from above or below and/or when viewed the front or back of the display device or display panel.

Aspects and embodiments of the present disclosure may include one or more of the present optional features:

In at least some of or in each of the planar shapes of the first semiconductor layer, the second semiconductor layer, and the light-emitting layer, one end of the at least one first side may be connected to one end of the at least one second side.

The at least one second side may have an arc shape.

At least one of or each of the planar shapes of the first semiconductor layer, the second semiconductor layer, and the light-emitting layer may be a semicircular shape.

At least one of or each of the planar shapes of the first semiconductor layer, the second semiconductor layer, and the light-emitting layer may be a D shape, e.g. made by cutting a part of a circle straight.

The at least one first side may include a plurality of first sides. The at least one second side may include a plurality of second sides. The plurality of first sides may face each other and/or the plurality of second sides may face each other.

The plurality of first sides and the plurality of second sides may be alternately disposed.

At least one of or each of the planar shapes of the first semiconductor layer, the second semiconductor layer, and the light-emitting layer may have a corner area with a round shape. A corner area may be formed between two first sides and/or may be formed by one second side. The light-emitting element may include two, four and/or an even number of corner areas.

At least one of or each of the planar shapes of the first semiconductor layer, the second semiconductor layer, and the light-emitting layer may be a Bunimovich stadium shape.

At least one of or each of the planar shapes of the first semiconductor layer, the second semiconductor layer, and the light-emitting layer may be a Sinai billiard shape.

The light-emitting element may further comprise a first electrode on the first semiconductor layer. The light-emitting element may further comprise a second electrode opposite to the first electrode and/or on the second semiconductor layer.

The display device may comprise a planarization layer on the plurality of transistors. The planarization layer may surround a side surface of the light-emitting element. The display device may further comprise a reflective layer on the planarization layer. The reflective layer may surround the side surface of the light-emitting element.

A planar shape of the reflective layer may comprise a plurality of third sides, a plurality of fourth sides, and/or a plurality of fifth sides. The plurality of third sides may face one another, and/or the plurality of fourth sides may face one another and/or the plurality of fifth sides may connect the plurality of third sides and the plurality of fourth sides.

The plurality of fifth sides may be positioned to surround the at least one second side. The planar shape of the reflective layer may comprise a notch on at least one of the plurality of fifth sides.

The notch may be concave in a direction of the light-emitting element.

The notch may be positioned on a straight line of a maximum emission azimuth angle derived from a far-field pattern based on an angle of point of a maximum emission for a position at which light derived from a near-field emission pattern of the light-emitting element is maximally emitted.

The display device may further comprise a planarization layer on the plurality of transistors. The planarization layer may surround a side surface of the light-emitting element. The planarization layer may include scattering particles.

The display device may further comprise: a reflective electrode below the planarization layer.

The display device may further comprise: a black matrix surrounding a periphery of the light-emitting element.

Other detailed matters of the embodiment are included in the detailed description and the drawings.

According to the present disclosure, the light emitted from the light-emitting element is reflected inside the light-emitting element in a disordered manner, such that the light, which is trapped in the light-emitting element without being extracted, may be minimized or at least reduced, thereby improving the external light extraction efficiency.

According to the present disclosure, the light, which is emitted in the direction toward the side surface of the light-emitting element, is extracted in the direction toward the front surface of the display device, thereby improving the efficiency in extracting the light to the outside.

According to the present disclosure, it is possible to improve luminance uniformity of light emitted toward the side surface of the light-emitting element.

The effects according to the present disclosure are not limited to the contents exemplified above, and more various effects are included in the present disclosure.

**BRIEF DESCRIPTION OF DRAWINGS**

The above and other aspects, features and advantages of the present disclosure will be more clearly understood from the following detailed description taken in conjunction with the accompanying drawings, in which:

FIG. 1 is a schematic cross-sectional view of a light-emitting element according to an embodiment of the present disclosure;

FIG. 2 is a top plan view schematically illustrating a planar shape of the light-emitting element according to an embodiment of the present disclosure;

FIG. 3 is a top plan view schematically illustrating another example of a planar shape of the light-emitting element according to an embodiment of the present disclosure;

FIG. 4 is a top plan view schematically illustrating still another example of a planar shape of the light-emitting element according to an embodiment of the present disclosure;

FIG. 5 is a top plan view schematically illustrating yet another example of a planar shape of the light-emitting element according to an embodiment of the present disclosure;

FIGS. 6A to 6I are top plan views for comparing and explaining the effects of the planar shapes of the light-emitting element according to an embodiment of the present disclosure;

FIG. 7 is a schematic configuration view of a display device according to an embodiment of the present disclosure;

FIG. 8 is a cross-sectional view of a subpixel of the display device according to an embodiment of the present disclosure;

FIG. 9 is a cross-sectional view of a subpixel of a display device according to another embodiment of the present disclosure;

FIG. 10A is a view illustrating a simulation result of a far-field emission pattern for the light-emitting element illustrated in FIG. 2;

FIG. 10B is a view illustrating a simulation result of a far-field emission pattern for the light-emitting element illustrated in FIG. 3;

FIG. 10C is a view illustrating a simulation result of a far-field emission pattern for the light-emitting element illustrated in FIG. 4;

FIG. 11 is a top plan view schematically illustrating planar shapes of a light-emitting element and a reflective layer of a display device according to another embodiment of the present disclosure;

FIG. 12 is a top plan view schematically illustrating another example of the planar shapes of the light-emitting element and the reflective layer of the display device according to another embodiment of the present disclosure;

FIG. 13 is a top plan view schematically illustrating still another example of the planar shapes of the light-emitting element and the reflective layer of the display device according to another embodiment of the present disclosure; and

FIG. 14 is a cross-sectional view of a subpixel of a display device according to still another embodiment of the present disclosure.

## DETAILED DESCRIPTION

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "comprising" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, various exemplary embodiments of the present disclosure will be described in detail with reference to the accompanying drawings.

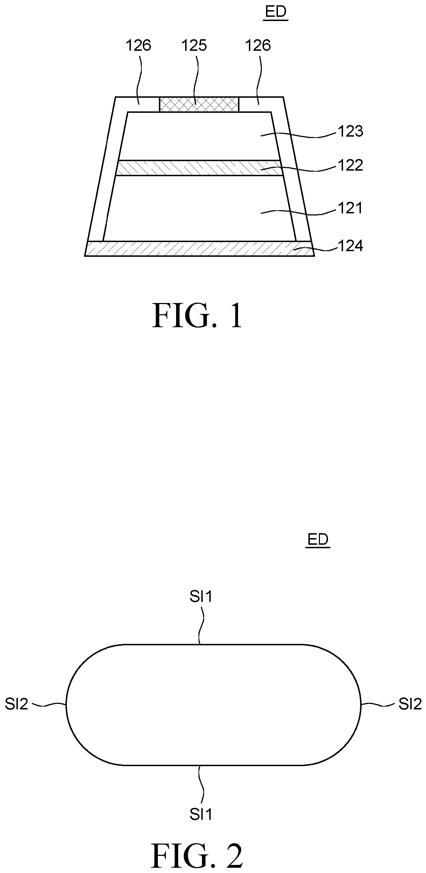

FIG. 1 is a schematic cross-sectional view of a light-emitting element according to an embodiment of the present disclosure.

With reference to FIG. 1, a light-emitting element ED includes a first semiconductor layer 121, a light-emitting layer 122, a second semiconductor layer 123, a first electrode 124, a second electrode 125, and an encapsulation layer 126.

The light-emitting element ED may have various structures such as lateral, vertical, and flip structures. The lateral light-emitting element includes the first and second electrodes horizontally disposed at two opposite sides of a light-emitting layer. The vertical light-emitting element includes the first and seconds electrodes disposed at upper and lower sides of the light-emitting layer. The flip light-emitting element is substantially identical in structure to the lateral light-emitting element. The lateral light-emitting element has the first and second electrodes horizontally disposed at the upper side of the light-emitting layer, whereas the flip light-emitting element has the first and second electrodes horizontally disposed at the lower side of the light-emitting layer. Hereinafter, the description is made on the assumption that the light-emitting element ED has the vertical structure. However, the types of the light-emitting elements ED are not limited thereto. The light-emitting element ED may have the lateral structure or the flip structure to which the technical spirit of the present disclosure is applied.

The first semiconductor layer 121 is disposed at a lower side of the light-emitting element ED. The first semiconductor layer 121 may be a layer formed by doping a particular material with n-type and p-type impurities. For example, the first semiconductor layer 121 may be a layer formed by doping a material, such as gallium nitride (GaN), indium aluminum phosphide (InAlP), or gallium arsenide (GaAs), with n-type and p-type impurities. In this case, the p-type impurity may be magnesium (Mg), zinc (Zn), beryllium (Be), or the like. The n-type impurity may be silicon (Si), germanium (Ge), tin (Sn), or the like. However, the present disclosure is not limited thereto. In the present disclosure, the first semiconductor layer 121 is defined as an n-type semiconductor layer, i.e., a layer doped with n-type impurities. However, the present disclosure is not limited thereto.

The light-emitting layer 122 and the second semiconductor layer 123 are disposed on the first semiconductor layer 121.

The light-emitting layer 122 may emit light by receiving positive holes and electrons from the first semiconductor layer 121 and the second semiconductor layer 123. The light-emitting layer 122 may be configured as a single layer or a multi-quantum well (MQW) structure. For example, the light-emitting layer 122 may be made of indium gallium nitride (InGaN), gallium nitride (GaN), or the like. However, the present disclosure is not limited thereto.

The second semiconductor layer 123 is disposed on the light-emitting layer 122. The second semiconductor layer 123 may be a layer formed by doping a particular material with n-type and p-type impurities. For example, the second semiconductor layer 123 may be a layer formed by doping a material, such as gallium nitride (GaN), indium aluminum phosphide (InAlP), or gallium arsenide (GaAs), with n-type and p-type impurities. Further, the p-type impurity may be magnesium (Mg), zinc (Zn), beryllium (Be), or the like. The n-type impurity may be silicon (Si), germanium (Ge), tin (Sn), or the like. However, the present disclosure is not limited thereto. In the present disclosure, the second semiconductor layer 123 is defined as a p-type semiconductor layer, i.e., a layer doped with p-type impurities. However, the present disclosure is not limited thereto.

The first electrode 124 is disposed below the first semiconductor layer 121. The first semiconductor layer 121 may be a semiconductor layer doped with n-type impurities, and the first electrode 124 may be a cathode. For example, the first electrode 124 is disposed on a bottom surface of the first semiconductor layer 121 and covers the bottom surface of the first semiconductor layer 121.

The first electrode 124 may be made of an electrically conductive material, for example, an opaque conductive material such as titanium (Ti), gold (Au), silver (Ag), copper (Cu), or an alloy thereof. However, the present disclosure is not limited thereto. For example, the first electrode 124 may be made of a transparent conductive material such as indium tin oxide (ITO) or indium zinc oxide (IZO).

The second electrode 125 is disposed on or above the second semiconductor layer 123. The second electrode 125 may be disposed on a top surface of the second semiconductor layer 123. In this case, the second semiconductor layer 123 may be a semiconductor layer doped with p-type impurities, and the second electrode 125 may be an anode. The second electrode 125 may be made of an electrically conductive material, for example, a transparent conductive material such as indium tin oxide (ITO) or indium zinc oxide (IZO) or an opaque conductive material such as titanium (Ti), gold (Au), silver (Ag), copper (Cu), or an alloy thereof. However, the present disclosure is not limited thereto.

The encapsulation layer 126 may be disposed to at least partially surround the first semiconductor layer 121, the light-emitting layer 122, the second semiconductor layer 123, and the second electrode 125. The encapsulation layer 126 may protect the first semiconductor layer 121, the light-emitting layer 122, and the second semiconductor layer 123. For example, the encapsulation layer 126 may cover a side surface of the first semiconductor layer 121, a side surface of the light-emitting layer 122, and a side surface of the second semiconductor layer 123. The encapsulation layer 126 may cover the entire side surface of the first semiconductor layer 121. However, the present disclosure is not limited thereto.

The light-emitting elements ED may include light-emitting elements configured to emit light beams with various colors. For example, the light-emitting element ED may be one of a red light-emitting element, a blue light-emitting element, and a green light-emitting element. However, the present disclosure is not limited thereto.

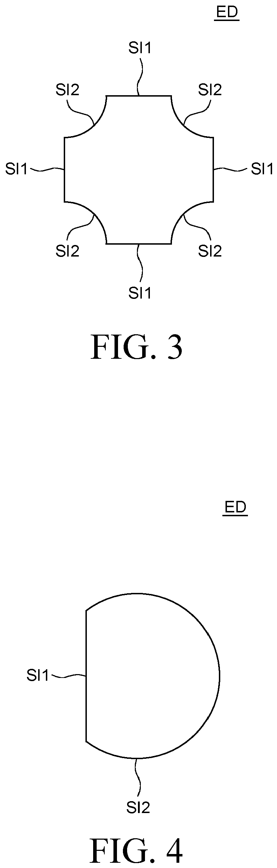

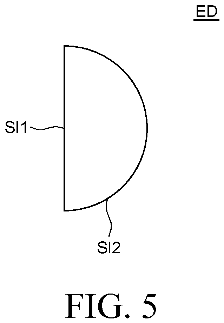

FIG. 2 is a top plan view schematically illustrating a planar shape of the light-emitting element according to an embodiment of the present disclosure. FIG. 3 is a top plan view schematically illustrating another example of a planar shape of the light-emitting element according to an embodiment of the present disclosure. FIG. 4 is a top plan view schematically illustrating still another example of a planar shape of the light-emitting element according to an embodiment of the present disclosure. FIG. 5 is a top plan view schematically illustrating yet another example of a planar shape of the light-emitting element according to an embodiment of the present disclosure. FIGS. 2 to 5 schematically illustrate the planar shapes without distinguishing specific configuration elements of the light-emitting element ED.

The planar shapes of the first semiconductor layer 121, the light-emitting layer 122, and the second semiconductor layer 123 of the light-emitting element ED may each include a first side SI1 with a straight shape, and a second side SI2 with a curved shape.

First, the planar shapes of the first semiconductor layer 121, the light-emitting layer 122, and the second semiconductor layer 123 of the light-emitting element ED may each include a plurality of first sides SI1 and a plurality of second sides SI2. In case that the planar shapes of the first semiconductor layer, the light-emitting layer, and the second semiconductor layer of the light-emitting element each include the plurality of first sides SI1 and the plurality of second sides SI2, the plurality of first sides SI1 and the plurality of second sides SI2 may be disposed alternately. Therefore, the plurality of first sides SI1 may be disposed at positions that face one another, and the plurality of second sides SI2 may be disposed at positions that face one another.

First, with reference to FIGS. 2 and 3 to describe the case in which the planar shapes of the first semiconductor layer, the light-emitting layer, and the second semiconductor layer of the light-emitting element each include the plurality of first sides SI1 and the plurality of second sides SI2, the planar shapes of the first semiconductor layer 121, the light-emitting layer 122, and the second semiconductor layer 123 of the light-emitting element ED may include the first sides SI1 and the second sides SI2 alternately disposed clockwise. Therefore, in each of the planar shapes of the first semiconductor layer 121, the light-emitting layer 122, and the second semiconductor layer 123 of the light-emitting element ED, the second sides SI2 may be disposed at two opposite sides of the first side SI1.

For example, as illustrated in FIG. 2, in case that the planar shapes of the first semiconductor layer 121, the light-emitting layer 122, and the second semiconductor layer 123 of the light-emitting element ED each include four sides, the two first sides SI1 having straight shapes may be disposed at upper and lower sides while facing each other, and the two second sides SI2 having arc shapes may be disposed at left and right sides while facing each other. For example, the planar shapes of the first semiconductor layer 121, the light-emitting layer 122, and the second semiconductor layer 123 of the light-emitting element ED may be Bunimovich stadium shapes.

As illustrated in FIG. 3, in each of the planar shapes of the first semiconductor layer 121, the light-emitting layer 122, and the second semiconductor layer 123 of the light-emitting element ED, corner areas each have a curved shape. For example, the corner area may have a round shape. One corner area may be arranged or connected between one first side SI1 and one second side SI2. For example, in case that the planar shapes of the first semiconductor layer 121, the light-emitting layer 122, and the second semiconductor layer 123 of the light-emitting element ED each include eight sides, the four first sides SI1 having straight shapes may be disposed at upper, lower, left, and right sides while facing one another, and the four second sides SI2 having arc shapes may be disposed at left upper, right upper, left lower, and right lower corner portions while facing one another. For example, the planar shapes of the first semiconductor layer 121, the light-emitting layer 122, and the second semiconductor layer 123 of the light-emitting element ED may be Sinai billiard shapes. However, FIG. 3 illustrates that the second side SI2 has a shape concave inward. However, the present disclosure is not limited thereto. The second side SI2 may be disposed in a shape convex outward.

Next, the planar shapes of the first semiconductor layer 121, the light-emitting layer 122, and the second semiconductor layer 123 of the light-emitting element ED may each include one first side SI1 and one second side SI2. In case that the planar shapes of the first semiconductor layer, the light-emitting layer, and the second semiconductor layer of the light-emitting element each include one first side SI1 and one second side SI2, one end of the first side SI1 may be connected to one end of the second side SI2. For example, two opposite ends of the one first side SI1 and two opposite ends of the one second side SI2 may be connected to one another. For example, one of two opposite ends of the one first side SI1 and one of two opposite ends of the one second side SI2 may be connected to one another, respectively.

With reference to FIGS. 4 and 5 to describe the case in which the planar shapes of the first semiconductor layer, the light-emitting layer, and the second semiconductor layer of the light-emitting element each include one first side SI1 and one second side SI2, the planar shapes of the first semiconductor layer 121, the light-emitting layer 122, and the second semiconductor layer 123 of the light-emitting element ED may each include one first side SI1 and one second side SI2. For example, the planar shapes of the first semiconductor layer 121, the light-emitting layer 122, and the second semiconductor layer 123 of the light-emitting element ED may each include the one first side SI1 with a straight shape, and the one second side SI2 with an arc shape. For example, in each of the planar shapes of the first semiconductor layer 121, the light-emitting layer 122, and the second semiconductor layer 123 of the light-emitting element ED, two opposite ends of the first side SI1 may be connected to two opposite ends of the second side SI2.

For example, as illustrated in FIG. 4, in case that the planar shapes of the first semiconductor layer 121, the light-emitting layer 122, and the second semiconductor layer 123 of the light-emitting element ED each include two sides, the second side SI2 with an arc shape may be disposed at one side of the first side SI1 with a straight shape, and the two opposite ends of the first side SI1 may be respectively connected to the two opposite ends of the second side SI2. In each of the planar shapes of the first semiconductor layer 121, the light-emitting layer 122, and the second semiconductor layer 123 of the light-emitting element ED, a length of the first side SI1 may be smaller than a diameter of the second side SI2. For example, the planar shapes of the first semiconductor layer 121, the light-emitting layer 122, and the second semiconductor layer 123 of the light-emitting element ED may each be a 'D' shape made by cutting a part of a circle straight. In the shape made by cutting a part of a circle straight, the first side SI1 may be a chord, i.e., a chord that does not pass through a center. The shape made by cutting a part of a circle straight may be a 'D' shape, and an area of the 'D' shape may be larger than an area of a semicircle. However, the present disclosure is not limited thereto. The area of the 'D' shape may be smaller than the area of the semicircle.

In addition, as illustrated in FIG. 5, in case that the planar shapes of the first semiconductor layer 121, the light-emitting layer 122, and the second semiconductor layer 123 of the light-emitting element ED each include two sides, the second side SI2 with an arc shape may be disposed at one side of the first side SI1 with a straight shape, and the two opposite ends of the first side SI1 may be respectively connected to the two opposite ends of the second side SI2. For example, in each of the planar shapes of the first semiconductor layer 121, the light-emitting layer 122, and the second semiconductor layer 123 of the light-emitting element ED, a length of the first side SI1 may be equal to a diameter of the second side SI2. For example, the planar shapes of the first semiconductor layer 121, the light-emitting layer 122, and the second semiconductor layer 123 of the light-emitting element ED may be semicircular shapes.

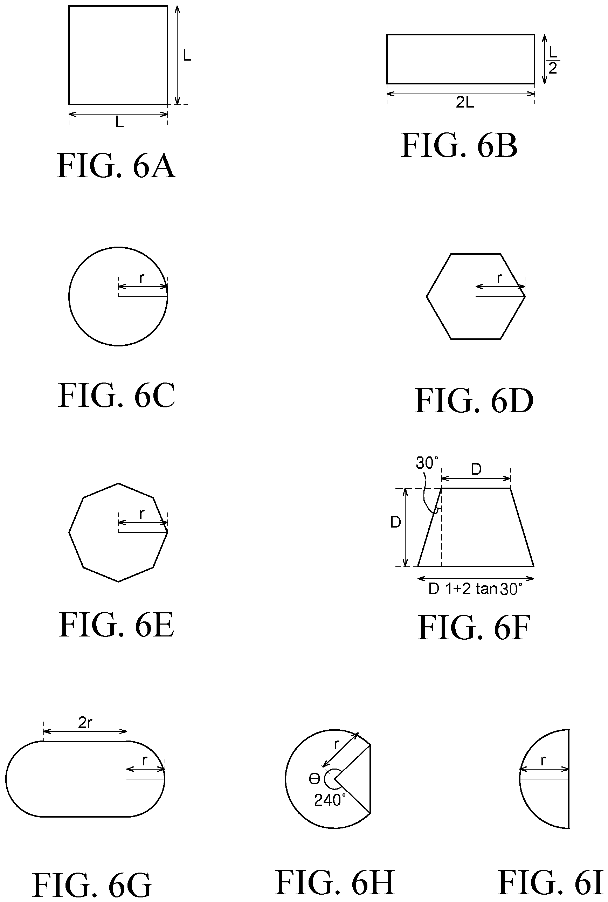

FIGS. 6A to 6I are top plan views for comparing and explaining the effects of the planar shapes of the light-emitting element according to an embodiment of the present disclosure.

Hereinafter, the effect of the present embodiment described above will be described in more detail with reference to Examples and Comparative Examples. However, the following examples are for exemplifying the present disclosure, and the scope of the present embodiment is not limited by the following examples. Examples and Comparative Examples will be described on the basis of the planar shape of the top surface of the light-emitting element ED, all the planar shapes of Examples and Comparative Examples have the same area.

[Comparative Example 1]

As illustrated in FIG. 6A, in Comparative Example 1, a square planar shape was prepared. In FIG. 6A, L represents a length of one of the sides constituting the square shape.

[Comparative Example 2]

As illustrated in FIG. 6B, in Comparative Example 2, a rectangular planar shape was prepared. In FIG. 6B, L represents a length of one of the sides constituting the square shape in FIG. 6A.

[Comparative Example 3]

As illustrated in FIG. 6C, in Comparative Example 3, a circular planar shape was prepared. In FIG. 6C, r is shown in Equation 1 below.

$$[\text{Equation 1}]$$

$$r = \frac{L}{\sqrt{\pi}}$$

[Comparative Example 4]

As illustrated in FIG. 6D, in Comparative Example 4, a hexagonal planar shape was prepared. In FIG. 6D, r is shown in Equation 2 below.

$$[\text{Equation 2}]$$

$$r = \frac{L}{\sqrt{6 \sin \frac{\pi}{12} \cos \frac{\pi}{12}}}$$

[Comparative Example 5]

As illustrated in FIG. 6E, in Comparative Example 5, an octagonal planar shape was prepared. In FIG. 6E, r is shown in Equation 3 below.

[Equation 3]

$$r = \frac{L}{\sqrt{8 \sin \frac{\pi}{16} \cos \frac{\pi}{16}}}$$

[Comparative Example 6]

As illustrated in FIG. 6F, in Comparative Example 6, a trapezoidal planar shape was prepared. In FIG. 6F, D is shown in Equation 4 below. D is a height of the trapezoidal shape.

[Equation 4]

$$D = \frac{L}{\sqrt{1 + \tan 30°}}$$

[Example 1]

As illustrated in FIGS. 2 and 6G, in Example 1, a planar shape, which was a Bunimovich stadium shape, was prepared. In FIG. 6G, r is shown in Equation 5 below.

[Equation 5]

$$r = \frac{L}{\sqrt{4 + \pi}}$$

[Example 2]

As illustrated in FIGS. 4 and 6H, in Example 2, a planar shape, which was a 'D' shape made by cutting a part of a circle straight, was prepared. In FIG. 6H, r is shown in Equation 6 below.

[Equation 6]

$$r = \frac{L}{\sqrt{\frac{2\pi}{3} + \frac{\sqrt{3}}{4}}}$$

[Example 3]

As illustrated in FIGS. 5 and 6I, in Example 3, a semicircular planar shape was prepared. In FIG. 6I, r is shown in Equation 7 below.

[Equation 7]

$$r = \frac{L}{\sqrt{\pi/2}}$$

Light extraction ratios of the light-emitting elements manufactured as described above were measured. The amount of light extracted from the light-emitting element ED was measured as the light extraction ratio. The results are shown in Table 1 below. In this case, the light extraction ratio refers to a ratio of light extracted to the outside of the light-emitting element to light emitted from the light-emitting element.

[Table 1]

|  | Com. Ex. 1 | Com. Ex. 2 | Com. Ex. 3 | Com. Ex. 4 | Com. Ex. 5 | Com. Ex. 6 | Ex. 1 | Ex. 2 | Ex. 3 |
|---|---|---|---|---|---|---|---|---|---|
| **Light extraction ratio (%)** | 66.0% | 65.8 % | 61.1 % | 78.44 % | 80.74 % | 78.82 % | 84.01 % | 83.97 % | 83.64 % |

With reference to Table 1, it can be seen that the light extraction ratios are higher in Examples 1, 2, and 3, in which the planar shape includes both the straight side and the curved side, than Comparative Example 1 having the square planar shape, Comparative Example 2 having the rectangular planar shape, Comparative Example 3 having the circular planar shape, Comparative Example 4 having the hexagonal planar shape, Comparative Example 5 having the octagonal planar shape, and Comparative Example 6 having the trapezoidal planar shape.

According to the experimental results, in case that the planar shape includes both the straight side and the curved side, the external light extraction efficiency may be improved.

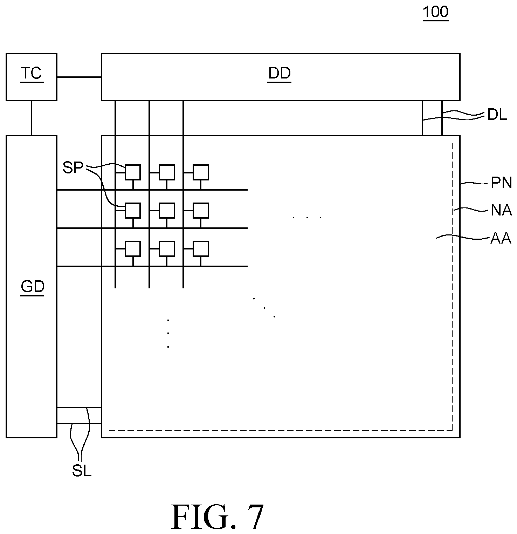

FIG. 7 is a schematic configuration view of a display device according to an embodiment of the present disclosure. For convenience of description, FIG. 7 illustrates only a display panel PN, a gate driver GD, a data driver DD, and a timing controller TC among various constituent elements of a display device 100.

With reference to FIG. 7, the display device 100 includes the display panel PN including a plurality of subpixels SP, the gate driver GD configured to supply various types of signals to the display panel PN, and the timing controller TC configured to control the data driver DD and the gate driver GD.

The gate driver GD supplies a plurality of scan signals to a plurality of scan lines SL in response to a plurality of gate control signals provided from the timing controller TC. FIG. 7 illustrates that the single gate driver GD is disposed to be spaced apart from one side of the display panel PN. However, the number and arrangement of the gate driver GD are not limited thereto.

The data driver DD supplies data voltages to a plurality of data lines DL in response to a plurality of data control signals and image data provided from the timing controller TC. The data driver DD may convert image data into data voltages by using a reference gamma voltage and supply the converted data voltages to the plurality of data lines DL.

The timing controller TC aligns image data, which are inputted from the outside, and supplies the image data to the data driver DD. The timing controller TC may generate the gate control signals and the data control signals by using synchronizing signals, i.e., dot clock signals, data enable signals, and horizontal/vertical synchronizing signals inputted from the outside. Further, the timing controller TC may control the gate driver GD and the data driver DD by supplying the generated gate control signals and data control signals to the gate driver GD and the data driver DD.

The display panel PN is configured to display images to a user and includes the plurality of subpixels SP. In the display panel PN, the plurality of scan lines SL and the plurality of data lines DL may intersect one another, and the plurality of subpixels SP may be formed at intersection points between the scan line SL and the data line DL.

A display area AA and a non-display area NA may be defined on the display panel PN.

The display area AA is an area of the display device 100 in which images are displayed. The display area AA may include the plurality of subpixels SP constituting a plurality of pixels PX, and a pixel circuit configured to operate the plurality of subpixels SP. The plurality of subpixels SP is minimum units that constitute the display area AA. The n subpixels SP may constitute a single pixel PX. Thin-film transistors and the like for operating a plurality of light-emitting elements may be respectively disposed in the plurality of subpixels SP. The plurality of light-emitting elements may be differently defined depending on the type of the display panel PN. For example, in case that the display panel PN is an inorganic light-emitting display panel PN, the light-emitting element may be a light-emitting diode (LED) or a micro light-emitting diode (micro LED or uLED).

A plurality of signal lines for transmitting various types of signals to the plurality of subpixels SP is disposed in the display area AA. For example, the plurality of signal lines may include the plurality of data lines DL for supplying data voltages to the plurality of subpixels SP, and the plurality of scan lines SL for supplying scan signals to the plurality of subpixels SP. The plurality of scan lines SL may extend in one direction in the display area AA and be connected to the plurality of subpixels SP. The plurality of data lines DL may extend in a direction different from one direction in the display area AA and be connected to the plurality of subpixels SP. In addition, a low-potential power line, a high-potential power line, and the like may be further disposed in the display area AA. However, the present disclosure is not limited thereto.

The non-display area NA may be defined as an area in which no image is displayed, i.e., an area extending from and/or adjacent to the display area AA. The non-display area NA may include link lines and pad electrodes for transmitting signals to the subpixels SP in the display area AA. Alternatively, the non-display area NA may include driver ICs such as gate driver ICs and data driver ICs.

Meanwhile, the non-display area NA may be positioned on a rear surface of the display panel PN, i.e., a surface on which the subpixel SP is not present. Alternatively, the non-display area NA may be excluded. However, the present disclosure is not limited to the configuration illustrated in the drawings.

Meanwhile, the drivers such as the gate driver GD, the data driver DD, and the timing controller TC may be connected to the display panel PN in various ways. For example, the gate driver GD may be mounted in the non-display area NA by a gate-in-panel (GIP) method or mounted between the plurality of subpixels SP by a gate-in-active area (GIA) method in the display area AA.

For example, the data driver DD and the timing controller TC may be formed on a separate flexible film and a printed circuit board and electrically connect the display panel PN, the data driver DD, and the timing controller TC by a method of bonding the flexible film and the printed circuit board to a pad electrode formed in the non-display area NA of the display panel PN.

As another example, in case that the gate driver GD is mounted in the display area AA by the GIA method and a side line SRL, which connects a signal line on a front surface of the display panel PN to the pad electrode on the rear surface of the display panel PN, is formed to bond the flexible film and the printed circuit board to the rear surface of the display panel PN, it is possible to minimize the non-display area NA on the front surface of the display panel PN. Therefore, in case that the gate driver GD, the data driver DD, and the timing controller TC are connected to the display panel PN by the above-mentioned method, a zero bezel in which the bezel is not substantially present may be implemented.

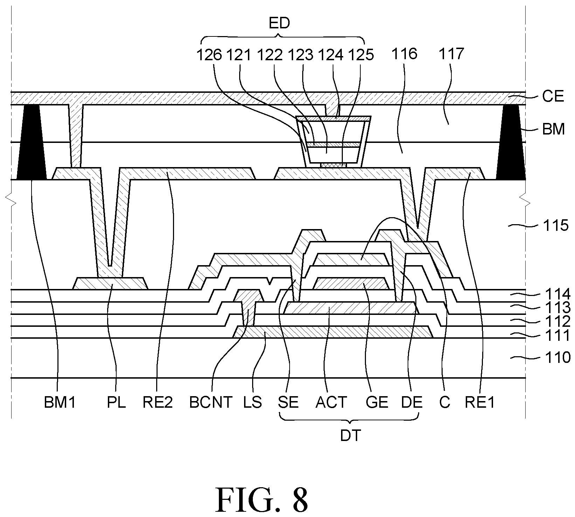

FIG. 8 is a cross-sectional view of a subpixel of the display device according to the embodiment of the present disclosure.

With reference to FIG. 8, the substrate 110 is a component for supporting various constituent elements included in the display device 100 and may be made of an insulating material. For example, the substrate 110 may be made of glass, resin, or the like. In addition, the substrate 110 may include plastic such as polymer and may be made of a material having flexibility.

A light-blocking layer LS is disposed on or below and/or corresponding to each of the plurality of subpixels SP and/or on the substrate 110. The light-blocking layer LS blocks light entering an active layer ACT of a driving transistor DT from a lower side of the substrate 110. The light-blocking layer LS may block light entering the active layer ACT of the driving transistor DT, thereby minimizing or at least reducing a leakage current.

A buffer layer 111 is disposed on the substrate 110 and the light-blocking layer LS. The buffer layer 111 may reduce the penetration of moisture or impurities through the substrate 110. For example, the buffer layer 111 may be configured as a single layer or multilayer made of silicon oxide (SiOx) or silicon nitride (SiNx). However, the present disclosure is not limited thereto. However, the buffer layer 111 may be excluded in accordance with the type of substrate 110 or the type of transistor. However, the present disclosure is not limited thereto.

The driving transistor DT is disposed on the buffer layer 111. The driving transistor DT includes the active layer ACT, a gate electrode GE, a source electrode SE, and a drain electrode DE.

The active layer ACT is disposed on the buffer layer 111. The active layer ACT may be made of a semiconductor material such as an oxide semiconductor, amorphous silicon, or polysilicon. However, the present disclosure is not limited thereto.

A gate insulation layer 112 is disposed on the active layer ACT. The gate insulation layer 112 is an insulation layer for insulating the active layer ACT and the gate electrode GE. The gate insulation layer 112 may be configured as a single layer or multilayer made of silicon oxide (SiOx) or silicon nitride (SiNx). However, the present disclosure is not limited thereto.

The gate electrode GE is disposed on the gate insulation layer 112. The gate electrode GE may be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

A first interlayer insulation layer 113 and a second interlayer insulation layer 114 are disposed on the gate electrode GE. Contact holes, through which the source electrode SE and the drain electrode DE are connected to the active layer ACT, are formed in the first interlayer insulation layer 113 and the second interlayer insulation layer 114. The first interlayer insulation layer 113 and the second interlayer insulation layer 114 may be insulation layers for protecting components disposed below the first interlayer insulation layer 113 and components disposed below the second interlayer insulation layer 114 and each configured as a single layer or multilayer made of silicon oxide (SiOx) or silicon nitride (SiNx). However, the present disclosure is not limited thereto.

A capacitor electrode C is disposed on the first interlayer insulation layer 113. The capacitor electrode C may be disposed to overlap the gate electrode GE with the first interlayer insulation layer 113 interposed therebetween. Therefore, the capacitor electrode C may maintain a voltage of the gate electrode GE of the driving transistor DT for a predetermined period of time.

The source electrode SE and the drain electrode DE are disposed on the second interlayer insulation layer 114 and electrically connected to the active layer ACT. The source electrode SE and the drain electrode DE may each be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

Meanwhile, in the present disclosure, the configuration has been described in which the first interlayer insulation layer 113 and the second interlayer insulation layer 114, i.e., the plurality of insulation layers is disposed between the gate electrode GE, the source electrode SE, and the drain electrode DE. However, only a single insulation layer may be disposed between the gate electrode GE, the source electrode SE, and the drain electrode DE. However, the present disclosure is not limited thereto.

Next, an auxiliary electrode BCNT is disposed on the gate insulation layer 112. The auxiliary electrode BCNT is an electrode configured to apply a voltage to the light-blocking layer LS disposed below the buffer layer 111. For example, the light-blocking layer LS may be electrically connected to other components disposed on the substrate 110 through the auxiliary electrode BCNT and receive a voltage. The light-blocking layer LS, which receives the voltage through the auxiliary electrode BCNT, does not operate as a floating gate, thereby minimizing or at least reducing a change in threshold voltage of the driving transistor DT caused by the floating light-blocking layer LS.

A power line PL is disposed on the second interlayer insulation layer 114. The power line PL may be electrically connected to the light-emitting element together with the driving transistor DT and allow the light-emitting element to emit light. For example, the power line PL may be a low-potential power line for supplying a low-potential power voltage or a high-potential power line for supplying a high-potential power voltage. However, the present disclosure is not limited thereto. The power line PL may be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

An organic insulation layer 115 is disposed on the driving transistor DT and the power line PL. The organic insulation layer 115 may planarize an upper portion of the substrate 110 on which the driving transistor DT is disposed. The organic insulation layer 115 may be configured as a single layer or multilayer and made of a photoresist or an acrylic-based organic material, for example. However, the present disclosure is not limited thereto.

A plurality of first reflective electrodes RE1 and a plurality of second reflective electrodes RE2, which are spaced apart from one another, are disposed on the organic insulation layer 115. The plurality of first reflective electrodes RE1 and the plurality of second reflective electrodes RE2 may serve to electrically connect the plurality of light-emitting elements ED to the power line PL and the driving transistor DT and also serve as reflective plates that reflect the light, which is emitted from the plurality of light-emitting elements ED, toward an upper side of the substrate 110 or a lower side of the substrate 110. The plurality of first reflective electrodes RE1 and the plurality of second reflective electrodes RE2 may each be made of an electrically conductive material with excellent reflection performance and reflect the light, which is emitted from the light-emitting element ED, toward the upper side. For example, the plurality of first reflective electrodes RE1 and the plurality of second reflective electrodes RE2 may each be made of a metallic material, such as aluminum (Al), silver (Ag), copper (Cu), palladium (Pd), or an alloy thereof, with excellent reflection performance. However, the present disclosure is not limited thereto.

The plurality of first reflective electrodes RE1 may electrically connect the light-emitting element ED to the driving transistor DT. The plurality of first reflective electrodes RE1 may be connected to the source electrode SE or the drain electrode DE of the driving transistor DT through contact holes formed in the organic insulation layer 115. Further, the first reflective electrode RE1 may be electrically connected to the second electrode 125 of the light-emitting element ED.

The plurality of second reflective electrodes RE2 may electrically connect the power line PL and the light-emitting element ED. The plurality of second reflective electrodes RE2 may be electrically connected to the power line PL through a contact hole formed in the organic insulation layer 115. Further, the plurality of second reflective electrodes RE2 may be electrically connected to a common electrode CE through contact holes in a first planarization layer 116 and a second planarization layer 117. Therefore, the first electrode 124 and the first semiconductor layer 121 of the light-emitting element ED may be electrically connected to the power line PL through the plurality of second reflective electrodes RE2 and the common electrode CE.

The light-emitting element ED is disposed on the first reflective electrode RE1 in each of the plurality of subpixels SP. The plurality of light-emitting elements ED may be elements configured to emit light by using an electric current and include the light-emitting elements configured to emit red light, green light, blue light, and the like. The plurality of light-emitting elements ED may implement light with various colors including white by using a combination of red light, green light, blue light, and the like. For example, the plurality of light-emitting elements ED may each be a light-emitting diode (LED) or a micro LED. However, the present disclosure is not limited thereto.

The plurality of light-emitting elements ED are light-emitting elements for displaying images to the user who looks at the display panel PN on the front surface of the substrate 110. The light emitted from the plurality of light-emitting elements ED may propagate to the upper side of the substrate 110. At least a part of the light emitted from the plurality of light-emitting elements ED may be reflected by the plurality of first reflective electrodes RE1 and the plurality of second reflective electrodes RE2 and propagate to the upper side of the substrate 110.

A black matrix BM is disposed on the organic insulation layer 115 and disposed between the plurality of light-emitting elements ED. The black matrix BM may be disposed to surround a periphery of the light-emitting element ED in each of the plurality of subpixels SP. The black matrix BM may block a part of the light, which is emitted from the light-emitting element ED and propagates toward the adjacent subpixel SP so that the colors of the light beams emitted from the plurality of subpixels SP are not mixed together. The black matrix BM may guide the light emitted from the light-emitting element ED so that the light is extracted to the upper side of the substrate 110 while corresponding only to the area of the subpixel SP in which the light-emitting element ED is disposed. Further, the black matrix BM may block a part of the light, which is emitted from the light-emitting element ED and propagates toward another adjacent subpixel SP so that the colors of the light beams emitted from the plurality of subpixels SP and the colors of the light beams emitted from another adjacent subpixel SP are not mixed together.

The first planarization layer 116 and the second planarization layer 117 are disposed to surround the plurality of light-emitting elements ED. The first planarization layer 116 is disposed on the plurality of first reflective electrodes RE1, the plurality of second reflective electrodes RE2, and the second planarization layer 117 is disposed on the first planarization layer 116. The first planarization layer 116 and the second planarization layer 117 may be disposed to fill the space between the black matrixes BM and fix and protect the plurality of light-emitting elements ED. The first planarization layer 116 and the second planarization layer 117 may each be configured as a single layer or multilayer and made of a photoresist or an acrylic-based organic material, for example. However, the present disclosure is not limited thereto.

The common electrode CE is provided on the second planarization layer 117 and disposed on the front surface of the substrate 110. The common electrode CE is an electrode for electrically connecting the power line PL and the plurality of light-emitting elements ED. The common electrode CE may be electrically connected to the plurality of second reflective electrodes RE2 through the contact holes in the first planarization layer 116 and the second planarization layer 117. Therefore, the common electrode CE may be electrically connected to the power line PL through the plurality of second reflective electrodes RE2. Further, the common electrode CE may be electrically connected to the first electrode 124 of each of the plurality of light-emitting elements ED through the contact hole in the second planarization layer 117.

The common electrode CE may be made of a transparent conductive material and transmit the light emitted from the light-emitting element ED. The light emitted from the light-emitting element ED disposed below the common electrode CE may pass through the common electrode CE and propagate toward the upper side of the substrate 110 and/or the upper side of the display device 100. For example, the common electrode CE may be made of a transparent conductive material such as indium tin oxide (ITO) or indium zinc oxide (IZO). However, the present disclosure is not limited thereto.

The display device 100 according to the embodiment of the present disclosure may extract the light, which is emitted from the light-emitting element ED, to outside of the light-emitting element ED, thereby minimizing or at least reducing the light that is trapped in the light-emitting element ED without being extracted. A general light-emitting element has a polygonal planar shape, such as a quadrangular planar shape, including straight lines. In this case, an incident angle in an in-plane direction of the light, which enters a side surface of the light-emitting element, is inevitably larger than a total reflection angle of the light propagating toward the outside of the light-emitting element. For this reason, there is a problem in that a loss of light because the light is trapped without being extracted from the inside to the outside of the light-emitting element because of the total reflection in the light-emitting element. Therefore, in the light-emitting element ED according to the embodiment of the present disclosure, the planar shapes of the first semiconductor layer 121, the light-emitting layer 122, and the second semiconductor layer 123 each include the plurality of first sides SI1 with a straight shape and the plurality of second sides SI2 with a curved shape, and the plurality of first sides SI1 and the plurality of second sides SI2 may be disposed alternately. In this case, the plurality of first sides SI1 may be disposed at positions that face one another, and the plurality of second sides SI2 may be disposed at positions that face one another. Therefore, the planar shape of the light-emitting element ED includes the straight lines and the curved lines, such that the light entering the light-emitting element ED may be reflected at disordered reflection angles. Therefore, the light emitted from the light-emitting element is reflected in the light-emitting element in a disordered manner, such that the light, which is trapped in the light-emitting element without being extracted, may be minimized, thereby improving the external light extraction efficiency.

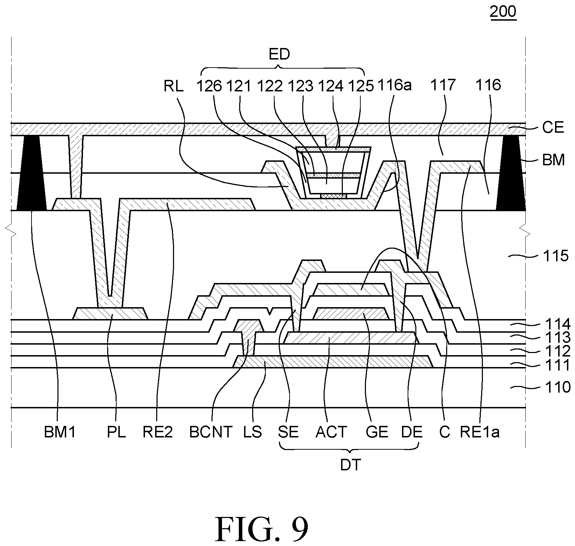

FIG. 9 is a cross-sectional view of a subpixel of a display device according to another embodiment of the present disclosure. A display device 200 in FIG. 9 is substantially identical in configuration to the display device 100 in FIG. 8, except for a reflective layer RL and a plurality of first reflective electrodes RE1a. Therefore, repeated descriptions of the identical components will be omitted.

With reference to FIG. 9, the first planarization layer 116 and the second planarization layer 117 may be disposed to surround a side surface of the light-emitting element ED.

The first planarization layer 116 may be disposed on the organic insulation layer 115. The first planarization layer 116 may include an opening portion 116a in which the light-emitting element ED is seated. The first planarization layer 116 may have an inclined surface inclined around the light-emitting element ED. The opening portion 116a may have an inclined surface. The first planarization layer 116 may be configured as a single layer or multilayer and made of a photoresist or an acrylic-based organic material, for example. However, the present disclosure is not limited thereto.

The first reflective electrode RE1a and the reflective layer RL may be disposed on the first planarization layer 116. The reflective layer RL may be disposed on a part of the organic insulation layer 115 opened by the opening portion 116a and electrically connected to the first electrode 124 of the light-emitting element ED. The reflective layer RL may be disposed on the inclined surface of the first planarization layer 116. The reflective layer RL may be disposed from a partial area on the organic insulation layer 115, which is opened by the opening portion 116a, to the inclined surface of the first planarization layer 116 and a part of the first planarization layer 116.

The first reflective electrode RE1a may be disposed on the first planarization layer 116, integrated with the reflective layer RL, and configured to electrically connect the light-emitting element ED to the driving transistor DT. The first reflective electrode RE1a may be connected to the source electrode SE or the drain electrode DE of the driving transistor DT through the contact holes formed in the organic insulation layer 115 and the first planarization layer 116.

The second reflective electrode RE2 may be disposed on the organic insulation layer 115. The second reflective electrode RE2 may electrically connect the plurality of light-emitting elements ED to the power line PL and the driving transistor DT. The second reflective electrode RE2 may electrically connect the power line PL and the light-emitting element ED. The second reflective electrode RE2 may be electrically connected to the power line PL through the contact hole formed in the organic insulation layer 115. Further, the second reflective electrode RE2 may be electrically connected to the common electrode CE through the contact holes in the first planarization layer 116 and the second planarization layer 117. Therefore, the first electrode 124 and the first semiconductor layer 121 of the light-emitting element ED may be electrically connected to the power line PL through the second reflective electrode RE2 and the common electrode CE.

The first reflective electrode RE1a and the second reflective electrode RE2 may electrically connect the plurality of light-emitting elements ED to the power line PL and the driving transistor DT. The reflective layer RL, the first reflective electrode RE1a, and the second reflective electrode RE2 may serve as reflective plates that reflect the light, which is emitted from the plurality of light-emitting elements ED, toward the upper side of the substrate 110.

The reflective layer RL, the first reflective electrode RE1a, and the second reflective electrode RE2 may each be made of an electrically conductive material with excellent reflection performance and reflect the light, which is emitted from the light-emitting element ED, toward the upper side. For example, the plurality of reflective layers RL, the plurality of first reflective electrodes RE1a, and the plurality of second reflective electrodes RE2 may each be made of a metallic material, such as aluminum (Al), silver (Ag), copper (Cu), palladium (Pd), or an alloy thereof, with excellent reflection performance. However, the present disclosure is not limited thereto. The first reflective electrode RE1a and the second reflective electrode RE2 may be referred to as reflective layers because the first reflective electrode RE1a and the second reflective electrode RE2 reflect the light, which is emitted from the light-emitting element ED, toward the upper side.

The second planarization layer 117 may be disposed on the first planarization layer 116, the reflective layer RL, and the first reflective electrode RE1a. The second planarization layer 117 may be disposed on the first planarization layer 116 and disposed to fill the opening portion 116a of the first planarization layer 116. The first planarization layer 116 and the second planarization layer 117 may be disposed to fill the space between the black matrixes BM and fix and protect the plurality of light-emitting elements ED.

In a display device 200 according to another embodiment of the present disclosure, the planar shape of the light-emitting element ED includes the straight line and the curved line, such that the light entering the light-emitting element ED is reflected at disordered reflection angles, such that the light, which is trapped in the light-emitting element without being extracted, may be minimized or at least reduced, thereby improving the external light extraction efficiency.

The display device 200 according to another embodiment of the present disclosure may allow the light, which is emitted in the direction toward the side surface of the light-emitting element, to be extracted in the direction toward the front surface of the display device by the reflective layer RL. The light emitted from the light-emitting element ED may not only be extracted in one direction but also extracted toward the side surface. In this case, the light extracted toward the side surface of the light-emitting element ED is trapped in the display device 200 without being extracted in the direction toward the front surface of the display device 200, which causes a problem in that the light extraction efficiency deteriorates. Therefore, in the display device 200 according to another embodiment of the present disclosure, the opening portion 116a, in which the light-emitting element ED is seated, may be disposed in the first planarization layer 116, and the inclined surface may be formed in the opening portion 116a. The reflective layer RL may be disposed on an upper portion of the organic insulation layer 115 exposed by the opening portion 116a of the first planarization layer 116, and the reflective layer RL may be disposed on the inclined surface of the first planarization layer 116. Therefore, the reflective layer RL is disposed on a lower portion of the light-emitting element ED and disposed at a position that surrounds the side surface of the light-emitting element ED, such that the light, which is emitted in the direction toward the side surface of the light-emitting element ED, may be extracted in the direction toward the front surface of the display device 200, thereby improving the efficiency in extracting the light to the outside. The reflective layer RL may be disposed between the organic insulation layer 115 and the light-emittin element ED.

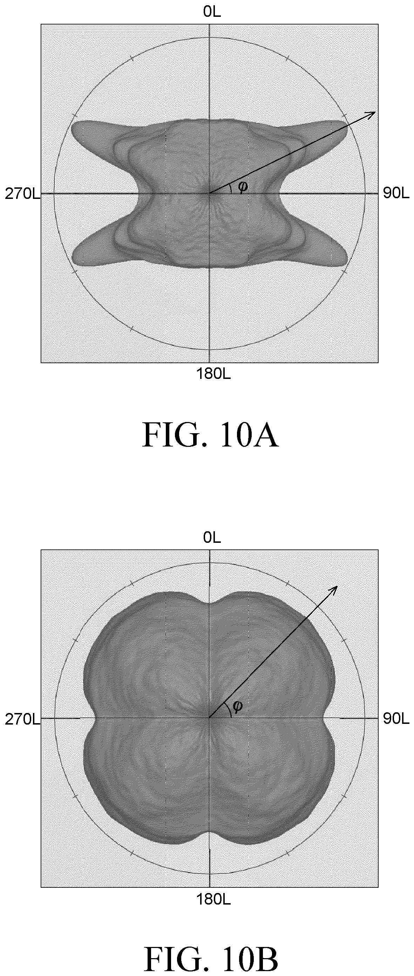

Hereinafter, the display device including the reflective layer configured to surround the light-emitting element will be described in more detail with reference to FIGS. 10A to 13.

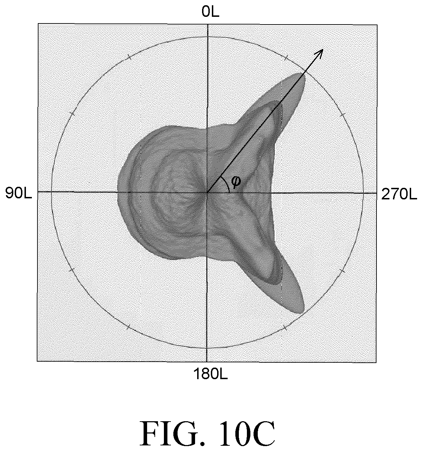

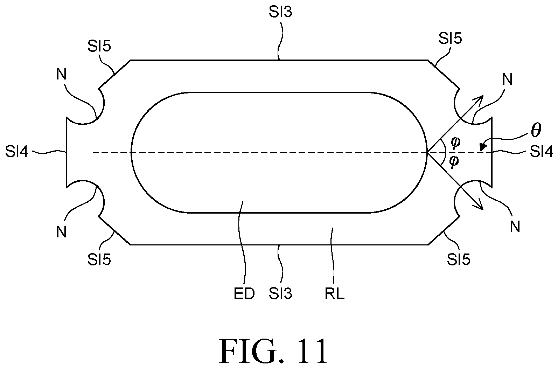

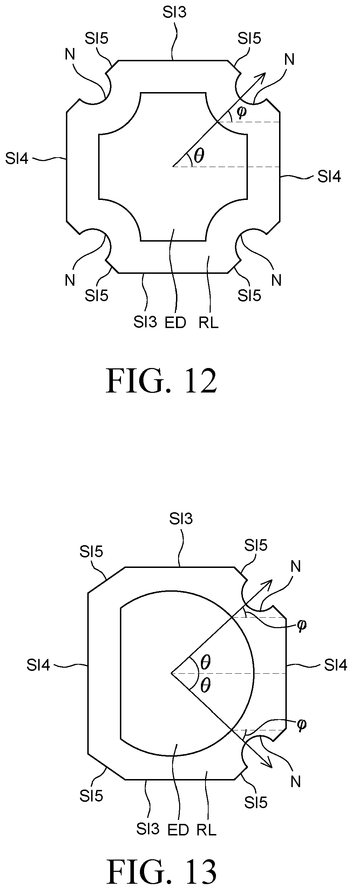

FIG. 10A is a view illustrating a simulation result of a far-field emission pattern for the light-emitting element illustrated in FIG. 2. FIG. 10B is a view illustrating a simulation result of a far-field emission pattern for the light-emitting element illustrated in FIG. 3. FIG. 10C is a view illustrating a simulation result of a far-field emission pattern for the light-emitting element illustrated in FIG. 4. FIG. 11 is a top plan view schematically illustrating planar shapes of a light-emitting element and a reflective layer of a display device according to another embodiment of the present disclosure. FIG. 12 is a top plan view schematically illustrating another example of the planar shapes of the light-emitting element and the reflective layer of the display device according to another embodiment of the present disclosure. FIG. 13 is a top plan view schematically illustrating still another example of the planar shapes of the light-emitting element and the reflective layer of the display device according to another embodiment of the present disclosure. For convenience of description, FIGS. 11 to 13 illustrate only the light-emitting element ED and the reflective layer RL among various constituent elements of the display device 200.

With reference to FIGS. 2 and 10A, in the far-field emission pattern for the light-emitting element ED illustrated in FIG. 2, the light amount may be uniformly distributed along the straight shape of the first side SI1 with the straight shape, whereas the light amount may be concentrated in a direction of an emission azimuth angle $\varphi$ of 35° to 45° (e.g., a direction of 40°) on the second side SI2 with the curved shape. The emission azimuth angle $\varphi$ may be measured with respect to an axis of symmetry of the light-emitting element ED and from a center of the light-emitting element ED, in particular an intersection of at least two axes of symmetry of the light-emitting element ED and/or a center of the area of the planar shape of the light-emitting element ED.

With reference to FIGS. 3 and 10B, in the far-field emission pattern for the light-emitting element ED illustrated in FIG. 3, the light amount may be uniformly distributed along the straight shape of the first side SI1 with the straight shape, whereas the light amount may be concentrated in a direction of an emission azimuth angle $\varphi$ of 40° to 50° (e.g., a direction of 45°) on the second side SI2 with the curved shape.

With reference to FIGS. 4 and 10C, in the far-field emission pattern for the light-emitting element ED illustrated in FIG. 4, the light amount may be uniformly distributed along the straight shape of the first side SI1 with the straight shape, whereas the light amount may be concentrated in a direction of an emission azimuth angle $\varphi$ of 45° to 55° (e.g., a direction of 50°) on the second side SI2 with the curved shape.

In the display device 200 according to another embodiment of the present disclosure, the planar shape of the light-emitting element ED includes the straight line and the curved line. The light emission amount is uniform on the first side SI1 with the straight shape of the planar shape of the light-emitting element ED, whereas the light emission amount is concentrated at a particular angle on the second side SI2 with the curved shape of the planar shape of the light-emitting element ED. Therefore, like a shape of a reflective layer generally used, in case that the reflective layer surrounds the light-emitting element and the planar shape of the reflective layer is formed to have an equal interval while having a shape identical to the planar shape of the light-emitting element, the non-uniformity of luminance may occur because the light emission amount varies depending on the azimuth angle, as illustrated in FIGS. 10A to 10C. A planar shape of the reflective layer may therefore be adapted to the planar shape of of the light-emitting element.

Therefore, with reference to FIGS. 11 to 13, in the display device 200 according to another embodiment of the present disclosure, notches N are formed at positions in the direction of the azimuth angle at which the light emission amount is concentrated in the planar shape of the reflective layer RL that surrounds the light-emitting element ED, such that the light may be dispersed in the direction of the azimuth angle, the luminance uniformity may be improved, and the light may be extracted.

In the display device 200 according to another embodiment of the present disclosure, the planar shape of the reflective layer RL, which surrounds the light-emitting element ED, may include a plurality of third sides SI3, a plurality of fourth sides SI4, and a plurality of fifth sides SI5. In case that the planar shape of the reflective layer RL includes the plurality of third sides SI3, the plurality of fourth sides SI4, and the plurality of fifth sides SI5, the plurality of third sides SI3 may be positioned at positions facing one another, and the plurality of fourth sides SI4 may be positioned at positions facing one another. In this case, the plurality of fifth sides SI5 may be disposed to connect the plurality of third sides SI3 and the plurality of fourth sides SI4. In this case, the plurality of fifth sides SI5 may be positioned to surround the second side SI2 with the curved shape of the light-emitting element ED.

With reference to FIGS. 10A to 10C together, in the display device 200 according to another embodiment of the present disclosure, the light emission amount of the light-emitting element ED is uniform in the direction of the first side SI1 with the straight shape, and the light emission amount is concentrated in a particular direction toward the second side SI2 with the curved shape. For example, even though the light emission amount at two opposite ends of the first side SI1 is larger in light intensity than the light emission amount at an angle of point of a maximum emission $\theta$ for the point at which the light is maximally emitted from the second side SI2, the emission angle of the first side SI1 is dispersed, such that the far-field may be uniformly distributed. Therefore, the light amount may be uniformly dispersed in the area of the first side SI1 even though there is no notch.

Therefore, in the display device 200 according to another embodiment of the present disclosure, the notch N included in the planar shape of the reflective layer RL may be disposed in at least one of the plurality of fifth sides SI5 that surrounds the second side SI2 of the light-emitting element ED.

In the planar shape of the reflective layer RL of the display device 200 according to another embodiment of the present disclosure, the notch N may be positioned on a straight line of a maximum emission azimuth angle (i.e., emission vector) derived from the far-field pattern based on an angle of point of a maximum emission for a position at which light derived from a near-field emission pattern of the light-emitting element ED is maximally emitted. Specifically, the notch N may be disposed such that a center of the notch N is positioned on the straight line at the maximum emission azimuth angle derived from the far-field pattern based on the angle of point of the maximum emission derived from the near-field emission pattern of the light-emitting element ED. For example, the shape of the notch N may include a groove having a curved surface concave in the direction of the light-emitting element ED. However, the present disclosure is not limited thereto.

With reference to FIGS. 2 and 11, the angle of point of the maximum emission θ is derived from the near-field emission pattern of the light-emitting element ED illustrated in FIG. 2 is 0°, and the maximum emission azimuth angle φ derived from the far-field pattern of the second light-emitting element ED in FIG. 10A is 40°.. (This can be an example to show the angle of point of the maximum emission θ shown in FIGs. 11, 12 and 13.) As illustrated in FIG. 11, the position of the notch N included in the planar shape of the reflective layer RL may be formed at the position straight with respect to the emission azimuth angle φ based on the angle of point of the maximum emission θ (i.e., a direction of 40° based on a direction of 0° of the second side SI2 at the center of the light-emitting element ED (a center of the second side SI2)). For example, a normal vector of the notch N included in the planar shape of the reflective layer RL faces the maximum emission azimuth angle φ of the light-emitting element ED at 180°. The emission azimuth angle θ may be measured with respect to an axis of symmetry of the light-emitting element ED and from a center of the light-emitting element ED, in particular an intersection of at least two axes of symmetry of the light-emitting element ED and/or a center of the area of the planar shape of the light-emitting element ED. The notch N may be arranged on the edge of the reflective layer RL at a first predetermined position. The first predetermined position may correspond to a position where the edge of the reflective layer RL crosses a first predetermined straight line. The first predetermined straight line may start from a second predetermined position at the maximum emission azimuth angle φ, wherein the second predetermined position may correspond to a position where the edge of the light-emitting element ED crosses a second predetermined straight line. The second predetermined straight line starts from the center of the lighte-emitting element ED as defined above at the maximum emission angle θ. In other words, the second predetermined straight line includes the center of the light-emitting element ED and is arranged at the maximum emission angle θ. The first predetermined straight line includes the second predetermined position and is arranged at maximum emission azimuth angle φ.

With reference to FIGS. 3 and 12, the angle of point of the maximum emission θ is derived from the near-field emission pattern of the light-emitting element ED illustrated in FIG. 3 is 45°, and the maximum emission azimuth angle φ derived from the far-field pattern of the second light-emitting element ED in FIG. 10B is 45°. As illustrated in FIG. 12, the position of the notch N included in the planar shape of the reflective layer RL may be formed at the position straight with respect to the emission azimuth angle φ based on the angle of point of the maximum emission θ (i.e., a direction of 45° based on a direction of 45° of the second side SI2 at the center of the light-emitting element ED).

With reference to FIGS. 4 and 13, the angle of point of the maximum emission θ is derived from the near-field emission pattern of the light-emitting element ED illustrated in FIG. 4 is 48°, and the maximum emission azimuth angle φ derived from the far-field pattern of the second light-emitting element ED in FIG. 10C is 50°. As illustrated in FIG. 13, the position of the notch N included in the planar shape of the reflective layer RL may be formed at the position straight with respect to the emission azimuth angle φ based on the angle of point of the maximum emission θ (i.e., a direction of 50° based on a direction of 48° of the second side SI2 at the center of the light-emitting element ED).

In the display device 200 according to another embodiment of the present disclosure, the notch N is formed to be positioned at the position in the direction of the azimuth angle at which the light emission amount is concentrated in the planar shape of the reflective layer RL that surrounds the light-emitting element ED, such that the notch N disperses the light in the direction of the azimuth angle in the area in which the light emission amount is concentrated, which may improve the luminance uniformity and extract the light.

In the display device 200 according to another embodiment of the present disclosure, the shape and size of the notch N may be used without limitation, and the shape and degree of the dispersion of the light emission amount may be adjusted by adjusting the size and shape of the notch N and the angle of the inclined surface at the periphery of the light-emitting element ED in which the reflective layer RL is disposed.

In the display device 200 according to another embodiment of the present disclosure, the light extraction may be improved as a spacing distance between the light-emitting element ED and the notch N included in the planar shape of the reflective layer RL decreases. However, the present disclosure is not limited thereto. The spacing distance may be adjusted in consideration of a margin of a transfer process.

In a display device 200 according to another embodiment of the present disclosure, the planar shape of the light-emitting element ED includes the straight line and the curved line, such that the light entering the light-emitting element ED is reflected at disordered reflection angles, such that the light, which is trapped in the light-emitting element without being extracted, may be minimized or at least reduced, thereby improving the external light extraction efficiency.

In the display device 200 according to another embodiment of the present disclosure, the reflective layer RL is disposed to surround the lower portion of the light-emitting element ED and the side surface of the light-emitting element ED, such that the light, which is emitted in the direction toward the side surface of the light-emitting element ED, may be extracted in the direction toward the front surface of the display device 200, thereby improving the efficiency in extracting the light to the outside.

In the display device 200 according to another embodiment of the present disclosure, the notches N are formed at the positions in the direction of the azimuth angle at which the light emission amount is concentrated in the planar shape of the reflective layer RL that surrounds the light-emitting element ED. In the area in which the light emission amount is concentrated, the notch N disperses the light in the direction of the azimuth angle, which may improve the light extraction efficiency and the luminance uniformity.

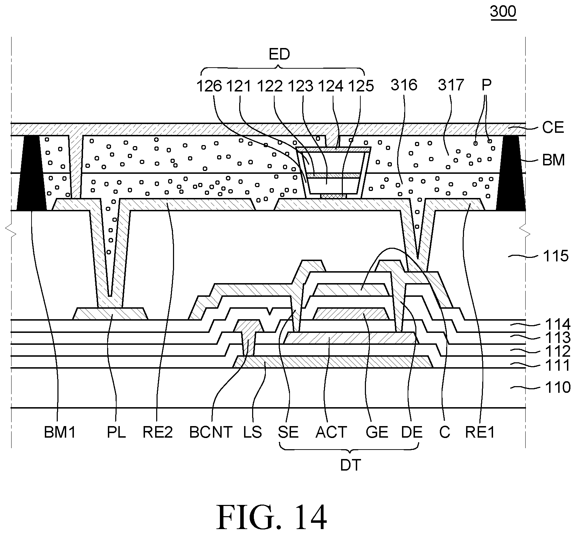

FIG. 14 is a cross-sectional view of a subpixel of a display device according to still another embodiment of the present disclosure. A display device 300 in FIG. 14 is substantially identical in configuration to the display device 100 in FIG. 8, except for a first planarization layer 316 and a second planarization layer 317. Therefore, repeated descriptions of the identical components will be omitted.

With reference to FIG. 14, the first planarization layer 316 and the second planarization layer 317 are disposed to surround the plurality of light-emitting elements ED. The first planarization layer 316 is disposed to surround the plurality of light-emitting elements ED, and the second planarization layer 317 is disposed to surround the first planarization layer 316. The first planarization layer 316 and the second planarization layer 317 may be disposed to surround the plurality of light-emitting elements ED. The first planarization layer 316 and the second planarization layer 317 may be disposed to fill the space between the black matrixes BM and fix and protect the plurality of light-emitting elements ED. The first planarization layer 316 and the second planarization layer 317 may each be configured as a single layer or multilayer and made of a photoresist or an acrylic-based organic material, for example. However, the present disclosure is not limited thereto.

At least one of the first planarization layer 316 and the second planarization layer 317 may include scattering particles P. The scattering particles P may be dispersed and disposed in the first planarization layer 316 and the second planarization layer 317. The scattering particles P may be made of a material that irregularly reflects or scatter the light. For example, the scattering particles P may be a nanoparticle made of a material including titanium (Ti). For example, the scattering particles P may be a particle having a size at a nanometer (nm) level and formed by a sol-gel process method. However, the present disclosure is not limited thereto.

The display device 300 according to another embodiment of the present disclosure may allow the light, which is emitted in the direction toward the side surface of the light-emitting element, to be extracted in the direction toward the front surface of the display device. The light emitted from the light-emitting element may not only be extracted in one direction but also extracted toward the side surface. In this case, the light extracted toward the side surface of the light-emitting element is trapped in the display device without being extracted in the direction toward the front surface of the display device, which causes a problem in that the light extraction efficiency deteriorates. Therefore, in the display device 300 according to another embodiment of the present disclosure, the first planarization layer 316 and the second planarization layer 317 may be disposed to surround the plurality of light-emitting elements ED. The first planarization layer 316 and the second planarization layer 317 may include the scattering particles P made of materials that irregularly reflect or scatter the light. Therefore, the scattering particles P are included in the first planarization layer 316 and the second planarization layer 317 disposed to surround the plurality of light-emitting elements ED, such that the light, which is emitted in the direction toward the side surface of the light-emitting element ED, may be extracted in the direction toward the front surface of the display device 300, thereby improving the efficiency in extracting the light to the outside.

The exemplary embodiments of the present disclosure can also be described as follows:

According to an aspect of the present disclosure, a light-emitting element includes a first semiconductor layer, a second semiconductor layer opposite to the first semiconductor layer, and a light-emitting layer between the first semiconductor layer and the second semiconductor layer, planar shapes of the first semiconductor layer, the second semiconductor layer, and the light-emitting layer each include at least one first side with a straight shape, and at least one second side with a curved shape.

In each of the planar shapes of the first semiconductor layer, the second semiconductor layer, and the light-emitting layer, one end of the first side may be connected to one end of the second side.

The second side may have an arc shape.

Each of the planar shapes of the first semiconductor layer, the second semiconductor layer, and the light-emitting layer may be a semicircular shape.

Each of the planar shapes of the first semiconductor layer, the second semiconductor layer, and the light-emitting layer may be a 'D' shape made by cutting a part of a circle straight.

The planar shapes of the first semiconductor layer, the second semiconductor layer, and the light-emitting layer each include a plurality of first sides and a plurality of second sides, and the plurality of first sides face each other, and the plurality of second sides may face each other.

The first sides and the second sides may be disposed alternately.

Each of the planar shapes of the first semiconductor layer, the second semiconductor layer, and the light-emitting layer may have a corner area with a round shape.

Each of the planar shapes of the first semiconductor layer, the second semiconductor layer, and the light-emitting layer may be a Bunimovich stadium shape.

Each of the planar shapes of the first semiconductor layer, the second semiconductor layer, and the light-emitting layer may be a Sinai billiard shape.

The light-emitting element may further include a first electrode disposed on the first semiconductor layer, and a second electrode disposed opposite to the first electrode and disposed on the second semiconductor layer.

According to another aspect of the present disclosure, a display device includes a substrate comprising a plurality of subpixels, a plurality of transistors disposed on the substrate, and a light-emitting element being disposed in each of the plurality of subpixels on the substrate.

The light-emitting element may further include a planarization layer disposed on the plurality of transistors and configured to surround a side surface of the light-emitting element, and a reflective layer disposed on the planarization layer and configured to surround the side surface of the light-emitting element.

The light-emitting element may include a first semiconductor layer, a second semiconductor layer opposite to the first semiconductor layer, and a light-emitting layer disposed between the first semiconductor layer and the second semiconductor layer, planar shapes of the first semiconductor layer, the second semiconductor layer, and the light-emitting layer each comprise at least one first side with a straight shape and at least one second side with a curved shape, a planar shape of the reflective layer may comprise a plurality of third sides, a plurality of fourth sides, and a plurality of fifth sides, the plurality of third sides faces one another, the plurality of fourth sides faces one another, and the plurality of fifth sides connects the plurality of third sides and the plurality of fourth sides.

The plurality of fifth sides may be positioned to surround the second side, the planar shape of the reflective layer may comprise a notch disposed on at least one of the plurality of fifth sides, and the display device may include a notch concave in a direction of the light-emitting element.

The light-emitting element may further include a planarization layer disposed on the plurality of transistors and configured to surround a side surface of the light-emitting element, the planarization layer may include scattering particles.

Although the exemplary embodiments of the present disclosure have been described in detail with reference to the accompanying drawings, the present disclosure is not limited thereto and may be embodied in many different forms without departing from the technical concept of the present disclosure.

## Claims

1. A light-emitting element (ED) comprising:

    a first semiconductor layer (121);
    a second semiconductor layer (123) opposite to the first semiconductor layer (121); and
    a light-emitting layer (122) arranged between the first semiconductor layer (121) and the second semiconductor layer (123),
    wherein planar shapes of the first semiconductor layer (121), the second semiconductor layer (123), and the light-emitting layer (122) each include at least one first side (SI1) with a straight shape and at least one second side (SI2) with a curved shape.

2. The light-emitting element of claim 1, wherein in each of the planar shapes of the first semiconductor layer, the second semiconductor layer, and the light-emitting layer, one end of the at least one first side (SI1) is connected to one respective end of the at least one second side (SI2).

3. The light-emitting element of the preceding claims, wherein the at least one second side (SI2) has an arc shape.

4. The light-emitting element of the preceding claims, wherein each of the planar shapes of the first semiconductor layer, the second semiconductor layer, and the light-emitting layer is a semicircular shape or a D shape.

5. The light-emitting element of the preceding claims, wherein the at least one first side includes a plurality of first sides and the at least one second side includes a plurality of second sides, and the plurality of first sides face each other and the plurality of second sides face each other, and/or wherein the plurality of first sides and the plurality of second sides are alternately disposed.

6. The light-emitting element of any one of the preceding claims, wherein each of the planar shapes of the first semiconductor layer, the second semiconductor layer, and the light-emitting layer has a corner area with a round shape or an arc shape,

wherein preferably, one corner area is formed between two first sides and/or is formed by one second side,
wherein preferably the light-emitting element includes two, four and/or an even number of corner areas.

7. The light-emitting element of any one of claims 1 to 5, wherein each of the planar shapes of the first semiconductor layer, the second semiconductor layer, and the light-emitting layer is a Bunimovich stadium shape, or
wherein each of the planar shapes of the first semiconductor layer, the second semiconductor layer, and the light-emitting layer is a Sinai billiard shape.

8. The light-emitting element of any one of the preceding claims, further comprising:

a first electrode (124) on the first semiconductor layer; and
a second electrode (125) opposite to the first electrode and on the second semiconductor layer.

9. A display device comprising:

a substrate (110) comprising a plurality of subpixels (SP);
a plurality of transistors (DT) disposed on the substrate (110) corresponding to each of the plurality of subpixels (SP); and
a plurality of light-emitting elements according to claim 1 disposed on the substrate (110), each light-emittnig emitting (ED) corresponding to one of the plurality of subpixels (SP).

10. The display device of claim 9, further comprising:

a planarization layer (116) on the plurality mof transistors (DT), the planarization layer (116) surrounding a side surface of each of the light-emitting elements (ED); and
a plurality of reflective layers (RL) disposed on the planarization layer (116) and/or between the planariziation layer (116) and a corresponding one of the light-emitting elements (ED), the reflective layer (116) surrounding the side surface of the corresponding light-emitting element (ED).

11. The display device of claim 10, wherein a planar shape of each of the reflective layers (RL) comprises a plurality of third sides (SI3), a plurality of fourth sides (SI4), and a plurality of fifth sides (SI5),

wherein the plurality of third sides (SI3) face one another,
wherein the plurality of fourth sides (SI4) face one another, and
wherein the plurality of fifth sides (SI5) connect the plurality of third sides (SI3) and the plurality of fourth sides (SI5).

12. The display device of claim 11, wherein the plurality of fifth sides (SI5) and/or the plurality of fourth sides (SI4) of the reflective layer (RL) are positioned to respectively surround the at least one second side (SI2) of the corresponding light emitting element (ED).

13. The display device of claim 11 or 12, wherein the planar shape of the reflective layer (RL) comprises a notch (N) on at least one of the plurality of fifth sides (SI5),
wherein the notch (N) is positioned on a straight line corresponding to a maximum emission azimuth angle ($\varphi$) derived from a far-field pattern of the light-emitting element (ED), the straight line starting from a position corresponding to a maximum emission angle ($\theta$) derived from a near-field emission pattern of the light-emitting element (ED).

14. The display device of claim 10, 11, 12 or 13, further comprising:

a planarization layer (116, 117) on the plurality of transistors (DT), the planarization layer (116, 117) surrounding a side surface of each of the light-emitting elements (ED),
wherein the planarization layer (116, 117) includes scattering particles.

15. The display device of any one of claims 10 to 14, further comprising a black matrix (BM) surrounding each of the light-emitting elements (ED).

ED

126    125    126

123

122

121

124

# FIG. 1

ED

SI1

SI2                    SI2

SI1

# FIG. 2

ED

SI1

SI2          SI2

SI1                    SI1

SI2          SI2

SI1

# FIG. 3

ED

SI1

SI2

# FIG. 4

ED

SI1

SI2

FIG. 5

FIG. 6A

FIG. 6B

FIG. 6C

FIG. 6D

FIG. 6E

FIG. 6F

FIG. 6G

FIG. 6H

FIG. 6I

100

TC

DD

DL

SP

PN

NA

AA

GD

SL

FIG. 7

ED

126 121 122 123 124 125    116    117

CE

BM

115

114
113
112
111

110

BM1    PL    RE2    BCNT    LS    SE    ACT    GE    DE    C    RE1

DT

# FIG. 8

200

ED

RL  126 121 122 123 124 125 116a  117  116

CE

BM

115

114
113
112
111

110

BM1    PL   RE2   BCNT  LS   SE   ACT   GE   DE   C  RE1a

DT

FIG. 9

FIG. 10A

FIG. 10B

FIG. 10C

FIG. 11

**FIG. 12**

**FIG. 13**

300

ED

126 121 122 123 124 125    316    317   P

CE

BM

115

114
113
112
111

110

BM1   PL   RE2   BCNT   LS   SE   ACT   GE   DE   C   RE1

DT

# FIG. 14

Europäisches
Patentamt

European
Patent Office

Office européen
des brevets

## EUROPEAN SEARCH REPORT

**Application Number**

EP 24 22 1806

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 3 991 339 A (LOCKWOOD HARRY FRANCIS ET AL) 9 November 1976 (1976-11-09) | 1-3,5,6, 8-12,14, 15 | INV. H10H20/819 |
| A | * figures 1,2 * | 7,13 | |
| X | US 2010/163895 A1 (HORIE HIDEYOSHI [JP]) 1 July 2010 (2010-07-01) | 1-4, 8-12,14, 15 | |
| A | * figures 1,6A-6B * | 7,13 | |
| X | US 2019/035978 A1 (SATO KOSUKE [JP]) 31 January 2019 (2019-01-31) | 1-3,5,6, 8-12,14, 15 | |
| A | * figures 1-4 * | 7,13 | |
| X | US 2008/290365 A1 (SAKAMOTO TAKAHIKO [JP] ET AL) 27 November 2008 (2008-11-27) | 1-3,5,6, 8-12,14, 15 | |
| A | * figures 1-2, 10-13C,14A-14B * | 7,13 | |
| X | US 2020/303605 A1 (JANG JONG MIN [KR] ET AL) 24 September 2020 (2020-09-24) * figures 1-3b * | 1-3,5,6, 8-12,14, 15 | TECHNICAL FIELDS SEARCHED (IPC) H10H |
| A | US 2017/125392 A1 (BIBL ANDREAS [US] ET AL) 4 May 2017 (2017-05-04) * figure 11 * | 9-12,15 | |

The present search report has been drawn up for all claims

| Place of search | Date of completion of the search | Examiner |
|---|---|---|
| The Hague | 23 May 2025 | Dehestru, Bastien |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 24 22 1806

This annex lists the patent family members relating to the patent documents cited in the above-mentioned European search report.
The members are as contained in the European Patent Office EDP file on
The European Patent Office is in no way liable for these particulars which are merely given for the purpose of information.

23-05-2025

| Patent document cited in search report | | Publication date | Patent family member(s) | | Publication date |
|---|---|---|---|---|---|
| US 3991339 | A | 09-11-1976 | NONE | | |
| US 2010163895 | A1 | 01-07-2010 | CN | 101379627 A | 04-03-2009 |
| | | | EP | 1986243 A1 | 29-10-2008 |
| | | | JP | 2007214276 A | 23-08-2007 |
| | | | KR | 20080095243 A | 28-10-2008 |
| | | | TW | 200739963 A | 16-10-2007 |
| | | | US | 2010163895 A1 | 01-07-2010 |
| | | | WO | 2007091432 A1 | 16-08-2007 |
| US 2019035978 | A1 | 31-01-2019 | CN | 109309151 A | 05-02-2019 |
| | | | JP | 6912962 B2 | 04-08-2021 |
| | | | JP | 2019029407 A | 21-02-2019 |
| | | | US | 2019035978 A1 | 31-01-2019 |
| | | | US | 2020403122 A1 | 24-12-2020 |
| US 2008290365 | A1 | 27-11-2008 | CN | 1938869 A | 28-03-2007 |
| | | | CN | 101587932 A | 25-11-2009 |
| | | | EP | 1746664 A1 | 24-01-2007 |
| | | | JP | 4320676 B2 | 26-08-2009 |
| | | | JP | 4320687 B2 | 26-08-2009 |
| | | | JP | 2008235940 A | 02-10-2008 |
| | | | JP | WO2005096399 A1 | 21-02-2008 |
| | | | KR | 20070011350 A | 24-01-2007 |
| | | | TW | I385815 B | 11-02-2013 |
| | | | US | 2006017061 A1 | 26-01-2006 |
| | | | US | 2008290365 A1 | 27-11-2008 |
| | | | WO | 2005096399 A1 | 13-10-2005 |
| US 2020303605 | A1 | 24-09-2020 | BR | 112021018573 A2 | 30-11-2021 |
| | | | CN | 113614918 A | 05-11-2021 |
| | | | EP | 3944314 A1 | 26-01-2022 |
| | | | JP | 7593934 B2 | 03-12-2024 |
| | | | JP | 2022526117 A | 23-05-2022 |
| | | | JP | 2025028066 A | 28-02-2025 |
| | | | KR | 20210130142 A | 29-10-2021 |
| | | | US | 2020303605 A1 | 24-09-2020 |
| | | | US | 2022376148 A1 | 24-11-2022 |
| | | | US | 2023411571 A1 | 21-12-2023 |
| | | | WO | 2020190046 A1 | 24-09-2020 |
| US 2017125392 | A1 | 04-05-2017 | CN | 105324858 A | 10-02-2016 |
| | | | EP | 2997608 A1 | 23-03-2016 |
| | | | JP | 6159477 B2 | 05-07-2017 |
| | | | JP | 2016522585 A | 28-07-2016 |
| | | | KR | 20160010537 A | 27-01-2016 |

EPO FORM P0459

For more details about this annex : see Official Journal of the European Patent Office, No. 12/82

page 1 of 2

**ANNEX TO THE EUROPEAN SEARCH REPORT**

**ON EUROPEAN PATENT APPLICATION NO.**                    EP 24 22 1806

This annex lists the patent family members relating to the patent documents cited in the above-mentioned European search report.
The members are as contained in the European Patent Office EDP file on
The European Patent Office is in no way liable for these particulars which are merely given for the purpose of information.

23-05-2025

| Patent document cited in search report | Publication date | Patent family member(s) | | Publication date |
|---|---|---|---|---|
| | | KR | 20170033905 A | 27-03-2017 |
| | | TW | 201515262 A | 16-04-2015 |
| | | TW | 201635584 A | 01-10-2016 |
| | | US | 2014367705 A1 | 18-12-2014 |
| | | US | 2015137153 A1 | 21-05-2015 |
| | | US | 2016111405 A1 | 21-04-2016 |
| | | US | 2017125392 A1 | 04-05-2017 |
| | | US | 2018182746 A1 | 28-06-2018 |
| | | US | 2019259739 A1 | 22-08-2019 |
| | | US | 2020219863 A1 | 09-07-2020 |
| | | US | 2021313305 A1 | 07-10-2021 |
| | | US | 2024014195 A1 | 11-01-2024 |
| | | WO | 2014204695 A1 | 24-12-2014 |

EPO FORM P0459

For more details about this annex : see Official Journal of the European Patent Office, No. 12/82

page 2 of 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240028058

- KR 1020240136522